Europäisches Patentamt

European Patent Office

Office européen des brevets

(19)

(11) **EP 0 767 001 A1**

(12) **EUROPEAN PATENT APPLICATION**
published in accordance with Art. 158(3) EPC

(43) Date of publication:
09.04.1997 Bulletin 1997/15

(51) Int. Cl.$^6$: **B01J 19/08**

(21) Application number: 95918180.1

(86) International application number:
PCT/JP95/00911

(22) Date of filing: 12.05.1995

(87) International publication number:
WO 95/34376 (21.12.1995 Gazette 1995/54)

(84) Designated Contracting States:
DE FR GB IT

(30) Priority: 16.06.1994 JP 134467/94

(71) Applicant: KOMATSU LTD.
Minato-ku Tokyo 107 (JP)

(72) Inventors:
• TSURUMAKI, Naoya
Kabushiki Kaisha Komatsu
Hiratsuka-shi Kanagawa 254 (JP)

• SAKURAGI, Shunichi
Kabushiki Kaisha Komatsu
Hiratsuka-shi Kanagawa 254 (JP)

(74) Representative: Selting, Günther, Dipl.-Ing. et al
Patentanwälte
von Kreisler, Selting, Werner
Postfach 10 22 41
50462 Köln (DE)

(54) **SURFACE TREATMENT METHOD BY GAS JETTING AND SURFACE TREATMENT DEVICE**

(57) An object of the present invention is to improve the quality of surface treatment and to enhance the work efficiency.

The gas (6) to be sprayed onto the surface of a treatment object (15) is heated and made into a plasma by a heating means (5) and thus enters a highly reactive state (excited state, activated state). The gas that has been heated and made into a plasma is then subjected to adiabatic expansion by a rubber nozzle (1), which results in a flow rate faster than the speed of sound. This gas (7) that has been given the flow rate faster than the speed of sound is then sprayed toward the surface of the treatment object (15). Thereupon, the gas (7) that has been heated and made into a plasma and has entered a highly reactive state reaches the treatment object (15), which is the spraying object, at ultrasonic speed in a short time.

FIG.1

EP 0 767 001 A1

## Description

TECHNICAL FIELD

This invention relates to a surface treatment method and apparatus using gas spraying with which the treatment surface is treated by spraying the treatment surface with a gas, and more particularly to a surface treatment method and apparatus that are favorable in applications such as the formation of a diamond thin film on a tool tip, and the formation of a semiconductor thin film on a variety of substrates.

BACKGROUND ART

There is a technique whereby a gas is converted into a plasma by induction plasma method or DC plasma jet method to render the gas in an activated state and in a state in which its reactivity with the treatment surface is increased, and this plasma gas is sprayed at high speed onto the treatment surface to perform a surface treatment. This technique is already known, and has been utilized in the formation of diamond films (diamond coatings) and the like.

This type of technique has been disclosed in Japanese Patent Application Laid-Open Nos. 2-26895, 2-64097, 2-39421, and 2-296796, for example.

When such a thin film formation process is conducted, the gas that has been converted into a plasma and entered a highly reactive state must be made to reach the spray target (the treatment surface) at ultrasonic speed and in a short time. If the gas is not sprayed within a short time, its highly reactive state (excited state, activated state) cannot be maintained, there is decrease in adhesion between the treatment object and the reaction product, and the reaction product can peel off, among other such problems. Also, if the gas is not sprayed within a short time, the film formation will be slow and the work efficiency will suffer.

Also, since the temperature of a plasma gas is extremely high, the gas must be in a state in which it has cooled to a temperature that the treatment object can withstand at the point when the treatment object is sprayed with the gas. If the gas should be sprayed while still at such a high temperature, the thin film treatment on the surface of the treatment object could be less than perfect.

In addition, there must be no impurities in the highly reactive gas that has been converted into a plasma. This is because the admixture of impurities diminishes the quality of the resulting film.

However, since the techniques discussed in the abovementioned Japanese Patent Application Laid-Open Nos. 2-26895 and 2-64097 make use of a nozzle constructed such that the gas does not reach ultrasonic speed, they do not satisfy the above requirement that the spraying be completed within a short time.

A technique for making the gas reach ultrasonic speed is indeed disclosed in the above-mentioned Japanese Patent Application Laid-Open No. 2-39421, but two types of gas are sprayed onto the treatment object through separate double-walled pipes. In this case, the low temperature gas in the center comes into contact with the high temperature gas around the outside downstream from the heating area, so there is no adiabatic expansion process, and this technique does not satisfy the requirement that the spraying be performed while the highly reactive state is maintained.

The technique discussed in the above-mentioned Japanese Patent Application Laid-Open No. 2-296796 is not an adiabatic expansion process because more gas is introduced further downstream after the gas has been made into a plasma. Specifically, while cooling is achieved by the introduced gas, the flow rate does not increase sufficiently, so this technique does not satisfy the above requirement that the spraying be completed in a short time.

Thus, none of the prior art satisfies all of the requirements when a thin film formation treatment or the like is being performed.

SUMMARY OF THE INVENTION

The present invention was conceived in light of this situation, and an object thereof is to allow all of the requirements to be satisfied when a thin film formation treatment or the like is being performed, and thereby to achieve an improvement in the quality of the surface treatment and an increase in work efficiency.

The object of the present invention is achieved by means of the following structure.

Specifically, the first of the present inventions is a surface treatment method using gas spraying, with which a treatment object is subjected to a surface treatment by spraying the surface of the treatment object with a gas, comprising the steps of:

heating and making into a plasma the gas that is to be sprayed onto the surface of the treatment object;
subjecting the gas that has been heated and made into a plasma to adiabatic expansion to achieve a flow rate faster than the speed of sound; and
spraying the gas that has been given the flow rate faster than the speed of sound toward the surface of the treatment object.

The second of the present inventions is a surface treatment apparatus using the same gas spraying, designed such that:

an ultrasonic nozzle is structured such that the gas passing through the nozzle is subjected to adiabatic expansion and is sprayed from the nozzle outlet at a flow rate faster than the speed of sound;
a heating means for heating and converting into a plasma the gas that passes through the nozzle is installed somewhere along the line of the ultrasonic nozzle; and

the gas to be sprayed onto the surface of the treatment object is supplied into the nozzle from a gas supply position that is further upstream along the gas flow path than the inlet of the ultrasonic nozzle or the installation position of the heating means, said supplied gas is heated and made into a plasma by the heating means, and said gas that has been heated and made into a plasma is sprayed from the nozzle outlet toward the surface of the treatment object.

With the third of the present inventions, the heating means is structured such that the gas is heated and made into a plasma without the use of an electrode that comes into direct contact with the plasma gas.

Strictly speaking, an "adiabatic" condition cannot be produced, but the term "adiabatic" is used in the sense that extremely little heat moves in or out.

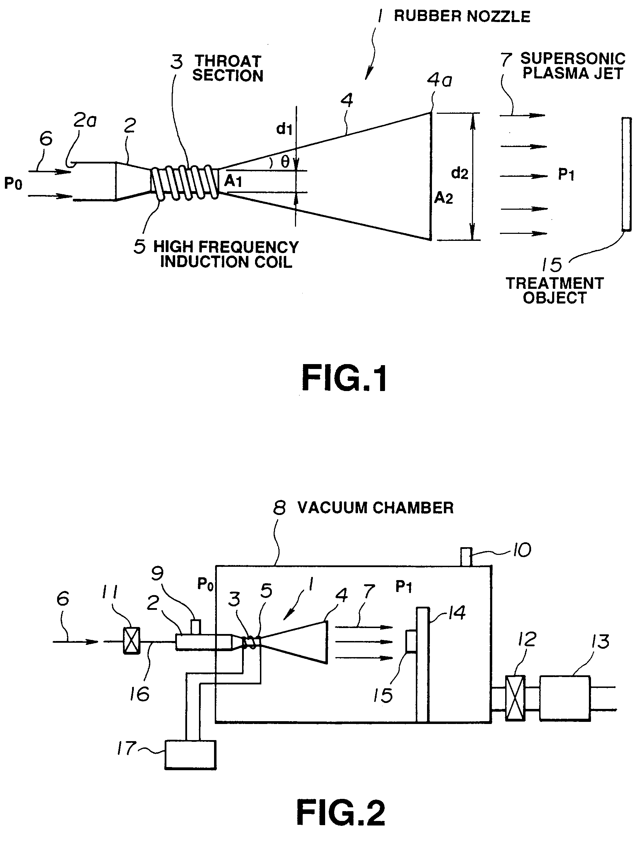

With the structures of the first and second inventions, as shown in Figure 1, a gas 6 that is to be sprayed onto the surface of a treatment object 15 is heated and made into a plasma by a heating means 5, and thus enters a highly reactive state (excited state, activated state).

This gas that has been heated and made into a plasma is then subjected to adiabatic expansion by means of an ultrasonic nozzle 1 to make the flow rate of the gas faster than the speed of sound. This gas 7 that has been given the flow rate faster than the speed of sound is then sprayed toward the surface of the treatment object 15. Accordingly, the gas 7 that has been heated and made into a plasma and is in a highly reactive state reaches the treatment object 15 at ultrasonic speed in a short time.

As a result, the gas 7 reacts with the surface of the treatment object 15 while still in a highly reactive state (excited state, activated state), so there is better adhesion between the treatment object 15 and the reaction product, and there are no problems such as the peeling of the reaction product. Also, the spraying is completed within a short time, the film is formed faster, and the work efficiency is improved. Furthermore, the temperature of the gas 7 that has been heated and made into a plasma is lowered by adiabatic expansion to a temperature that the treatment object 15 is capable of withstanding, so the quality of the thin film treatment is improved on the surface of the treatment object 15.

With the structure of the third invention, the gas is heated and made into a plasma without the use of an electrode that comes into direct contact with the plasma gas, so there is no admixture of the impurities (electrode materials) that accompany the consumption of the electrode into the highly reactive plasma gas, and there is an improvement in the quality of the surface treatment of the film or the like.

BRIEF DESCRIPTION OF THE DRAWINGS

Figure 1 is a diagram of the structure of an embodiment of the surface treatment method and apparatus by gas spraying pertaining to the present invention; and

Figure 2 is a diagram of the structure of another embodiment.

BEST MODE FOR CARRYING OUT THE INVENTION

Embodiments of the surface treatment method and apparatus by gas spraying pertaining to the present invention will now be described through reference to the figures.

**First Embodiment**

Figure 1 is a diagram of the structure of the apparatus in this embodiment. As shown in this figure, a rubber nozzle 1 (also called a divergent nozzle), which serves as the ultrasonic nozzle under the conditions discussed below, is structured such that the gas that passes through the nozzle is subjected to adiabatic expansion and is sprayed from a nozzle outlet 4a at a flow rate $u$ that is greater than the speed of sound $a$.

The rubber nozzle 1 is constricted in the middle, and comprises a gas introduction pipe 2 that is structured such that its cross sectional area gradually decreases in the direction of gas movement and such that the gas 6 (such as a mixed gas of $CH_4$ and $H_2$) to be sprayed onto the surface of the treatment object 15 (such as a cutting tool tip) is introduced from a gas introduction inlet 2a; a throat section 3 that has the smallest cross sectional area A1 (diameter d1) of the entire nozzle; and a gas spray pipe 4 whose cross sectional area gradually expands at a specific divergence angle $\theta$ and from which the gas 7 is sprayed from the nozzle outlet 4a which has the largest cross sectional area A2 (diameter d2). The rubber nozzle 1 is positioned such that the gas 7 that is sprayed from the nozzle outlet 4a will be sprayed toward the surface of the treatment object 15.

An induction plasma apparatus is installed in the throat section 3. Specifically, an inductive coil 5 is wound around the outside of the throat section 3, so that a high-frequency current can be passed through the inductive coil 5. Accordingly, an inductive electromagnetic field is formed inside the throat section 3 when current is passed through the coil 5, and the gas passing through the throat section 3 is heated and made into a plasma. Thus, the induction plasma apparatus is an electrode-less plasma apparatus that makes use of an inductive electromagnetic field, and unlike a DC plasma apparatus, there is no direct contact between the plasma gas and an electrode, and there is none of the admixture into the plasma gas of the electrode material (such as tungsten) that would otherwise accompany the consumption of the electrode, so the admixture of impurities can be prevented.

Let us now assume that the high-density mixed gas 6 to be sprayed onto the treatment object 15 is supplied from the gas introduction inlet 2a to the interior of the rubber nozzle 1. As a result, since a high-frequency current is passed through the high-frequency inductive coil 5 in the throat section 3 as discussed above, an inductive electromagnetic field is generated within the line, and the energy of this field causes the high-density gas to be heated and made into a plasma.

This high-density gas that has been heated and made into a plasma expands and accelerates due to the widening of the nozzle in the gas spray pipe 4 on the downstream side, and is sprayed from the gas spray 4a outlet as an ultrasonic plasma jet 7.

According to the vapor dynamics theory, in the case of a two-atom vapor, for example, the ratio P1/P0 between the stagnation pressure P0 of the introduced gas 6 and the pressure P1 downstream at the spray outlet 4a is approximately 0.52 or less, and if the ratio (divergence ratio) A2/A1 between the cross sectional area A1 of the throat section 3 and the cross sectional area A2 of the spray outlet 4a exceeds 1, the gas will undergo adiabatic expansion, and the spray flow rate will be ultrasonic, that is, the flow rate $u$ will be greater than the speed of sound $a$.

Since peeling of the boundary layer at the wall surface will occur if the divergence angle $\theta$ before and after the throat section 3 is to large, a suitable angle must be selected, such as about 15°.

The high-density gas that has been heated and made into a plasma in the throat section 3 is excited by this heat into a state of high reactivity, that is, a state in which it readily reacts with the treatment object 15. However, the temperature of this highly reactive gas is extremely high, in some cases going well over 10,000 degrees, and if this gas were sprayed directly onto the treatment object 15, the treatment object 15 might not be able to withstand this temperature.

In this regard, since the rubber nozzle 1 is designed so as to result in adiabatic expansion as discussed above, the gas is rapidly cooled in this adiabatic expansion process, and drops to a suitable temperature by the time it reaches the treatment object 15. The temperature at this point is determined by the above-mentioned divergence ratio A2/A1, so the desired temperature can be obtained by varying the design conditions of the nozzle 1. Thus, the gas 7 that is sprayed over the treatment object 15 can be set to a temperature that is suited to the treatment, so the quality of the film formation treatment or the like can be improved.

Further, since the highly reactive gas 7 moves at the ultrasonic speed $u$, the time it takes for it to reach the spray object 15 is extremely short, so the excitation state produced by the heating and plasma conversion does not return to the original state (a state in which it is difficult for a reaction to occur) by the time the gas reaches the spray object 15. It is thus possible to lower the temperature to a suitable level with the so-called excitation state frozen. Therefore, the adhesion between the treatment object 15 and the reaction product is increased, and there are no problems such as peeling of the reaction product. Thus, the quality of the film formation treatment or the like can be improved. Also, since the spraying is completed in a short time, the film formation is faster and work efficiency is enhanced.

The phenomenon described above will be described as follows by means of the one-dimensional vapor dynamics theory. Specifically, the relationship between flow rate and fluid temperature in the adiabatic flow of a perfect gas is expressed by the following formula. In the following formula, ( )n represents "n-th power."

$$T0 = T + (1/2) \cdot \{(\gamma - 1) / (\gamma \cdot R)\} \cdot (u)2 \quad (1)$$

Or

$$T0/T = 1 + \{(\gamma - 1) / 2\} \cdot (M)2 \quad (2)$$

Where

TO     is the overall temperature of the flow (roughly equivalent to the temperature of the throat section 3, which is the heating section),

T     is the static temperature of the flow (the so-called "temperature"),

$\gamma$     is the ratio of specific heat of the gas,

R     is the gas constant,

$u$     is the flow rate, and

M     is the Mach number.

The above Formula 2 is the product of rewriting the above Formula 1 using the each number ($u/a$, $a$: speed of sound). The Mach number M is defined as the relation of the divergence ratio A2/A1.

It can be seen from the above Formula 1 that since the overall temperature T0 is held at a constant value throughout the adiabatic expansion process, there is an increase in the flow rate $u$ and a decrease in the static temperature T. In other words, the greater is the flow rate, the more sharply the temperature decrease occurs.

The above Formula 2 shows that the value of the temperature ratio T0/T1 increases in proportion to the square of the Mach number M. For example, in the case of a two-atom vapor ($\gamma = 1.4$), the temperature ratio T0/T1 equals 6 when the Mach number M equals 5. Specifically, it can be seen that the plasma temperature T can be lowered to a temperature more suited to the treatment object 15 if the reactive plasma that has been heated to a high temperature is accelerated up to a high Mach number through adiabatic expansion using the rubber nozzle 1. Also, since the plasma particles here are accelerated to an extremely high speed (for instance, when T = 1500 (K), $\gamma = 1.4$, R = 500 (J/kgK), and M = 5, then $u = 5123$ (m/sec)), the time it takes the gas to reach the treatment object 15 is extremely short, and the plasma is able to reach the treatment object 15 at a low temperature while still more or less retaining its initial state of activity.

Since this low-temperature high-speed plasma flow 7 that has a high degree of activity is supplied to the treatment object 15 in the form of a particle flux with good directionality, another advantage is that the usage efficiency of the raw material gas is extremely high.

Furthermore, no impurities originating in the electrode material are admixed into the plasma, as mentioned above.

Thus, with this embodiment, a gas with high density, high reactivity, and an extremely low impurity content can be sprayed onto the treatment object 15 after being lowered to the desired temperature, and as a result, the work efficiency can be markedly improved, and the treatment quality can also be greatly enhanced.

The coil 5 was installed in the throat section 3 in this embodiment, but this is not a requirement, and the coil 5 can be provided to any location in the nozzle 1.

**Second Embodiment**

Figure 2 illustrates a embodiment in which the outlet pressure P1 of the nozzle 1 can be adjusted to the desired pressure, and the pressure ratio P1/P0 can be set to the desired value. Those structural components that are the same as in Figure 1 are labeled with the same symbols, and redundant description will be omitted.

As shown in Figure 2, the throat section 3 and the gas spray pipe 4 are installed inside a vacuum chamber 8, and a support 14 that supports the treatment object 15 is also installed inside the vacuum chamber 8. The air inside the vacuum chamber 8 is exhausted by an exhaust pump 13. The amount of gas supplied to the gas introduction pipe 2 is regulated by a gas supply regulator valve 11 that is installed along a gas supply pipe 16, and the outlet pressure P1 of the sprayed gas 7 is regulated by a P1 regulator valve 12. The pressure P0 inside the gas introduction pipe 2 is monitored by a P0 measurement gauge 9, and the outlet pressure P1 of the gas spray pipe 4 is monitored by a P1 measurement gauge 10. These monitoring results are used as a feedback signal to regulate the above-mentioned regulator valves 11 and 12, and to set the pressure ratio P1/P0 to the specified value. 17 is a high frequency power source that sends current to the high-frequency inductive coil 5.

In our experiment, a mixed gas of $CH_4$ and $H_2$ was used as the supplied gas 6, and the treatment object 15 was a cutting tool tip. The divergence ratio A2/A1 was set to approximately 6, and the P1 regulator valve 12 and the supply regulator valve 11 were regulated such that the pressure inside the chamber would be approximately 10 mTorr and the pressure ratio P1/P0 would be approximately 1.4/1000. Under these conditions, the Mach number M of the ultrasonic plasma jet 7 is approximately 5.

A current of 13.56 MHz was passed through the high-frequency inductive coil 5 at 1 kW while cooling was performed.

As a result, a mixed gas that contained carbon and had a high density and high reactivity was sprayed at ultrasonic speed and supplied onto the tip 15. This formed on the tip 15 a thin film that had good adhesion with said tip 15. This thin film was evaluated by X-ray analysis and Raman spectroscopy, which revealed it to be a good-quality diamond polycrystalline film containing no graphite. The film thickness after five minutes of spraying (film formation) was 20 μm.

This formation of a diamond thin film (diamond coating) resulted in a marked increase in the durability of the tool tip 15.

An experiment was also conducted using $SiH_4$ or a mixed gas 6 of $SiH_4$ and $H_2$ as the raw material gas and using a ceramic substrate 15 as the spray object, with all the other conditions being the same as above, the results of which are given below.

A mixed gas that contained silicon and had a high density and high reactivity was supplied onto the substrate 15, and a silicon thin film was formed over the ceramic substrate 15. This silicon thin film was evaluated by SEM observation and X-ray analysis, which revealed it to be a compact polycrystalline film. The thickness of the silicon thin film after 30 minutes of spraying (film formation) was approximately 60 μm.

Similarly, if $NH_4$ gas or $B_2H_6$ gas, for example, is used as the raw material gas 6, a film of c-BN can be formed.

Depending on the type of raw material gas 6, etching, oxidation, nitriding, and various other surface treatments can also be performed.

In this embodiment, the gas was heated and made into a plasma by means of the high-frequency inductive coil 5, but another electrode-less plasma apparatus, such as an ECR plasma or a helicon plasma, may also be used.

Jet shield technology involving an inert gas, a raw material gas, a dilution gas, or the like that is used in ordinary plasma flame spraying or plasma welding may also be applied.

In this embodiment, all of the gas 6 to be sprayed onto the treatment object 15 was supplied from the gas introduction inlet 2a which served as the inlet to the nozzle 1 (First Embodiment) or from the gas introduction inlet 2a via the supply pipe 16, but the gas 6 can be supplied at any location as long as it is further upstream along the gas flow path than the installment position of the coil 5, which is the position where the gas 6 is heated and made into a plasma.

Impurities must be added when a semiconductor film is to be grown. In view of this, the doping material used to form a p-type and n-type semiconductor should be mixed with $SiH_4$ or another gas, and this mixed gas 6 supplied from a position further upstream than the coil 5, which is the position where the gas is heated and made into a plasma.

However, since the doping material is in an extremely small amount, even if the doping material alone is supplied from a position further downstream than the installment position of the above-mentioned coil 5, there will be no hindrance to the adiabatic expan-

sion of the SiH$_4$ or other gas. Thus, the doping material, but only the doping material, may be supplied from a position further downstream than the position where the gas is heated and made into a plasma.

As described above, with the present invention, a highly reactive gas with a low impurity content is produced, the temperature of this gas is lowered to a temperature that is suitable for the treatment by the time the treatment object is reached, and the highly reactive gas reaches the treatment object at ultrasonic speed in a short period of time, so the treatment can be completed in a short time while the reactivity is still high. As a result, there is a marked increase in the quality of the thin film treatment or the like, and the work efficiency is also markedly enhanced.

INDUSTRIAL APPLICABILITY

The present invention is not limited to the formation of thin films, and can be applied to a wide range of industrial fields in which a surface treatment is performed by gas spraying.

**Claims**

1. A surface treatment method using gas spraying, with which a treatment object is subjected to a surface treatment by spraying the surface of the treatment object with a gas, said surface treatment method by gas spraying comprising the steps of:

    heating and making into a plasma the gas that is to be sprayed onto the surface of the treatment object;

    subjecting the gas that has been heated and made into a plasma to adiabatic expansion to achieve a flow rate faster than the speed of sound; and

    spraying the gas that has been given the flow rate faster than the speed of sound toward the surface of the treatment object.

2. A surface treatment method using gas spraying as defined in Claim 1, wherein all of the gas to be sprayed onto the surface of the treatment object is supplied from a position further upstream along the gas flow path than the position where the gas is heated and made into a plasma.

3. A surface treatment apparatus using gas spraying, with which a treatment object is subjected to a surface treatment by spraying the surface of the treatment object with a gas, wherein said surface treatment apparatus by gas spraying is designed such that:

    an ultrasonic nozzle is structured such that the gas passing through the nozzle is subjected to adiabatic expansion and is sprayed from the nozzle outlet at a flow rate faster than the speed of sound;

    a heating means for heating and converting into a plasma the gas that passes through the nozzle is installed somewhere along the line of the ultrasonic nozzle; and

    the gas to be sprayed onto the surface of the treatment object is supplied into the nozzle from a gas supply position that is further upstream along the gas flow path than the inlet of the ultrasonic nozzle or the installation position of the heating means, said supplied gas is heated and made into a plasma by the heating means, and said gas that has been heated and made into a plasma is sprayed from the nozzle outlet toward the surface of the treatment object.

4. A surface treatment apparatus by spraying as defined in Claim 3, wherein the heating means is structured such that the gas is heated and made into a plasma without the use of an electrode that comes into direct contact with the plasma gas.

## FIG.1

3 THROAT SECTION

1 RUBBER NOZZLE

4a

7 SUPERSONIC PLASMA JET

2a  2

6

$P_0$

$d_1$

$\theta$

4

$A_1$

$d_2$

$A_2$

$P_1$

5 HIGH FREQUENCY INDUCTION COIL

15 TREATMENT OBJECT

## FIG.1

8 VACUUM CHAMBER

10

6  11  9  $P_0$

3  5  1  4  7  $P_1$

2

14

16

15

12  13

17

## FIG.2

| INTERNATIONAL SEARCH REPORT | International application No. |
|---|---|
| | PCT/JP95/00911 |

**A. CLASSIFICATION OF SUBJECT MATTER**

Int. Cl$^6$ B01J19/08

According to International Patent Classification (IPC) or to both national classification and IPC

**B. FIELDS SEARCHED**

Minimum documentation searched (classification system followed by classification symbols)

Int. Cl$^6$ B01J19/08, B01J19/00

| Documentation searched other than minimum documentation to the extent that such documents are included in the fields searched | |
|---|---|
| Jitsuyo Shinan Koho | 1926 - 1995 |
| Kokai Jitsuyo Shinan Koho | 1971 - 1995 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP, 62-247836, A (Canon Inc.), October 28, 1987 (28. 10. 87), 2nd line from the bottom, upper left column to line 2, lower left column, page 2, Fig. 1 (Family: none) | 1 - 4 |
| X | JP, 1-179789, A (Fujitsu Ltd.), July 17, 1989 (17. 07. 89), Line 9, upper right column to 1st line from the bottom, lower left column, page 4 & EP, 286306, A1 | 1 - 4 |

☐ Further documents are listed in the continuation of Box C.     ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| July 14, 1995 (14. 07. 95) | August 1, 1995 (01. 08. 95) |

| Name and mailing address of the ISA/ | Authorized officer |
|---|---|
| Japanese Patent Office | |
| Facsimile No. | Telephone No. |

Form PCT/ISA/210 (second sheet) (July 1992)

8